# EUROPEAN PATENT APPLICATION

(11) **EP 1 328 019 A1**
(43) Date of publication of application: **16.07.2003**
(21) Application number: 02000603.7
(22) Date of filing: 10.01.2002
(51) Int. Cl.: H01L 23/367

(54) **Leaf piece structure for heat dissipater**

(71) Applicant: Wei, Wen-Chen, Taipei Hsien (TW)
(72) Inventor: Wei, Wen-Chen, Taipei Hsien (TW)
(74) Representative: Zeitler, Giselher (DE)

(57) **Abstract**

The invention herein of a leave piece structure for a heat dissipater is mainly constructed by punch pressing the piece-shaped heat dissipation pieces into heat dissipation poles arranged in a plurality of rows; the dissipation poles are staggered fore and aft in rows with intervals to substantially increase the contact area with the air; the retaining portions are formed by bending the two sides and the bottom end respectively in the same direction; the bottom end is thus defined as a heat conducting piece; the retaining tenons are mounted on the front portions of the retaining slots on the retaining portion to be aligned and retained correspondingly with all the heat dissipation leaves for assembling a heat dissipater.

## Description

### BACKGROUND OF THE INVENTION

### 1) FIELD OF THE INVENTION

A leaf piece structure for a heat dissipater, more especially a structure design is capable of increasing the entire area and the rate of heat dissipation for accelerating the heat diffusion and lowering the temperature.

### 2) DESCRIPTION OF THE PRIOR ART

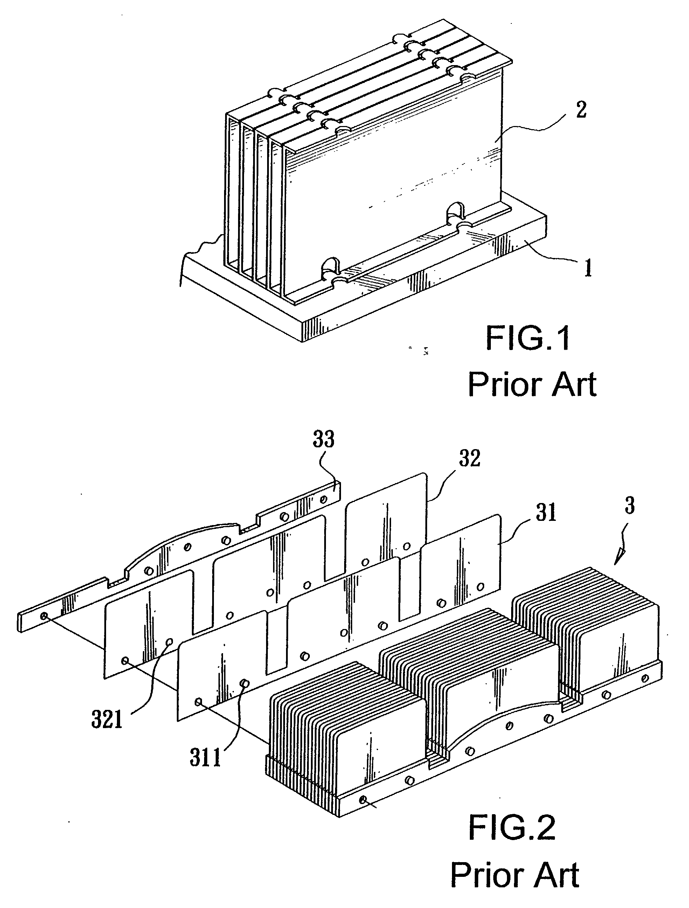

In order to solve the overheating problem of the components inside the computer central processing unit, the heat dissipater with heat dissipation fins are usually added to the components of the electronic heat sources, such as the CPU, the IC components, the power chips and the electric source supplier, to enable the high temperature generated by the electronic components to be conducted and diffused into the air through the heat dissipation fins and the surface contacting the air. However, the structure of most of the conventional heat dissipater comprises of the heat dissipation pieces (2) mounted on the base plate (1) of the heat dissipater and the base plate (1) is kept in firm contact under pressure against the electronic heat generating components to conduct and diffuse the high temperature generated by the electronic components during execution outwards through the heat dissipation pieces (2). However, this kind of heat dissipater is molded and assembled by compression casting the heat dissipation pieces (2) to be glued with the base plate (1). During assembling, the interval distance among the heat dissipation pieces are larger, therefore the number of the heat dissipation pieces are less, the heat dissipation area is also reduced; furthermore, the strip ribs and the edge frames of this kind of heat dissipation pieces are thicker with more heat accumulation, slower heat conducting rate and limited heat dissipation efficiency for the electronic heat generating components required for fast and longer execution. Therefore, the industrial field had developed another assembled heat dissipater, as indicated in FIG. 2. The assembled retainable heat dissipater (3) is formed by punch pressing and mainly comprised of convex blocks (311) mounted on the male heat dissipation pieces (31) and through holes (321) mounted on the female heat dissipation pieces (32) to be interlocked to form a heat dissipater. Although the heat dissipation pieces of this kind of heat dissipater are thinner, and the number of the heat dissipation pieces and the heat dissipation areas are increased, the manufacturing process is time-consuming since the long heat dissipation strips needed to be fabricated first, then they are to be cased to each other with adapted damper piece (33), which not only causes the material wastage, but also requires high cost and is not considered as an ideal structure.

In view of the shortcomings of the conventional heat dissipater mentioned above, the inventor of the invention herein, researched diligently based on the professional experience for improvement and innovation, and culminated in the invention of the structure of the heat dissipation leaves for a heat dissipater not only capable of fabricating more quantity of heat dissipation poles to have more heat dissipation poles in the same size of area and more air contact surface than what the conventional heat dissipater have, to not only efficiently increase the heat dissipation area, but also save more material than what the conventional ones can do, to further lower the cost and obtain the greatest heat dissipation effect, to accelerate the heat dissipation efficiency of the heat source, to fulfill the function of the hear dissipater and to specifically solve the overheating problems of the components in the computer.

### SUMMARY OF THE INVENTION

Therefore, the primary objective of the invention herein is to provide a structure of the heat dissipation leaves through punch pressing and bending the heat dissipation piece to form heat dissipation poles arranged in plurality for substantially increasing the surface area of heat dissipation poles contacting the air in the same size of area used so as to accelerate the heat dissipation efficiency.

Another objective of the invention herein is to provide a leaf structure for the heat dissipater through the extended retaining portion bent respectively in the same direction from the two sides and the bottom end of the heat dissipation leaves for the heat dissipation leaves to be aligned and retained correspondingly to assemble a heat dissipater.

Yet another objective of the invention herein is to provide a leaf structure for the heat dissipater, through directly cutting and bending the heat dissipation leaves into a plurality of heat dissipation poles without wasting any materials, but saving the materials, reducing the labor time and lowering the cost.

To enable a further understanding of the objectives, technology, methods and features of the specific structure of the invention herein, the brief description of the drawings below is followed by the detailed description of the preferred embodiment.

### BRIEF DESCRIPTION OF THE DRAWINGS

Figure 1 is a pictorial drawing of the conventional heat dissipater.
Figure 2 is a pictorial drawing of another conventional heat dissipater.
Figure 3 is a pictorial drawing of the invention herein.
Figure 4 is a pictorial and isometric drawing of the assembled invention herein.
Figure 5 is a pictorial drawing of the outside view of the assembled invention herein.

### DETAILED DESCRIPTION OF THE PREFERRED EMBODIMENTS

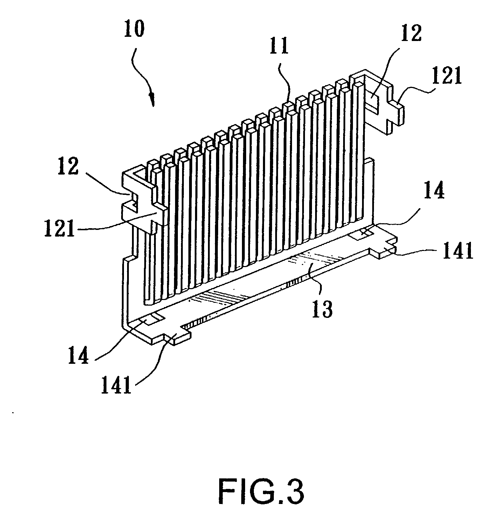

Referring to FIG. 3 of the pictorial drawing of the invention herein, mainly the heat dissipation leaf (10) are punch pressed as a whole to form heat dissipation poles (11) arranged in a plurality of rows; the heat dissipation poles (11) are long, narrow and square columns allowing all four sides of each pole to contact with the air and thus to substantially increase the contact area with the air and to strengthen the heat dissipation capacity; furthermore, the heat dissipation poles (11) are bent with intervals and staggered fore and aft in two parallel rows to define more heat dissipation gaps for increasing the moving space for the air current, reducing the disturbance of the interfering current and enabling the smooth air convection.

The retaining portion mounted with the side retaining slots (12) are formed by bending the two sides of the top ends of the heat dissipation leaves (10); the retaining portion with the bottom retaining slots (14) are formed by bending the bottom ends in the same direction of the side retaining slots (12), wherein, the side retaining tenons (121) are disposed at the front ends of the said side retaining slots (12) and the bottom retaining tenons (141) are mounted at the front ends of the said bottom retaining slots (14) for respectively inserting and retaining the side retaining tenons (121) and the bottom retaining tenons (141) with the side retaining slots (12) and the bottom retaining slots (14) and for further aligning and retaining accordingly all the heat dissipation leaves (10) fore and aft to assemble the heat dissipater.

The bottom end of the heat dissipation leaves (10) are also bent to form the heat conducting pieces (13) in the shape of long pieces with flat bottoms to make the bottom portions form compact contact surfaces for heat conduction by combining the heat conducting pieces during assembling for fully absorbing the heat source.

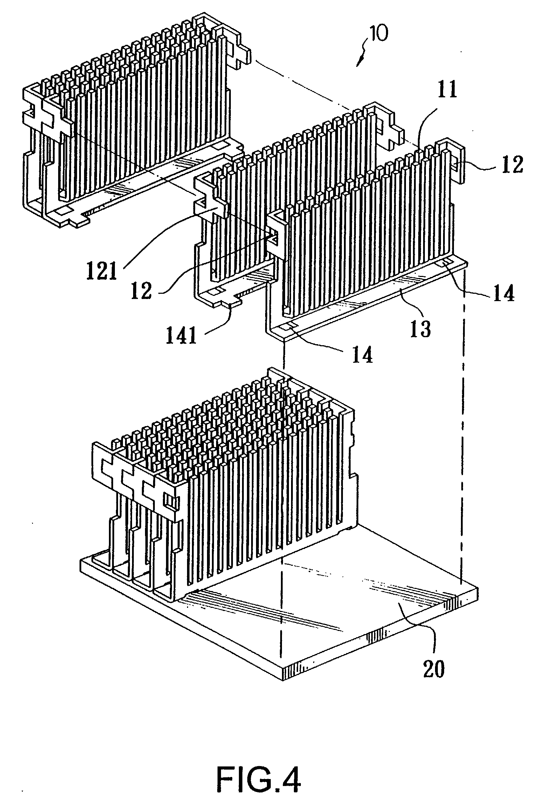

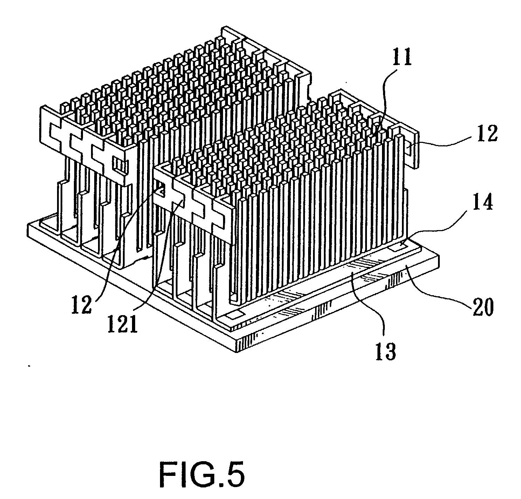

Referring to FIGs. 4 and 5 of the pictorial and isometric drawing and the pictorial drawing of the outside view of the assembled invention herein, when assembling, the side retaining tenons (121) on the heat dissipation leaves (10) will be inserted and retained into the side retaining slots (12) of the front heat dissipation leaves; at the same time, the bottom retaining tenons (141) will be inserted and retained respectively with the bottom retaining slots (14) of the front heat dissipation leaves; after inserting and retaining the heat dissipation leaves fore and aft following this order, the assembled will be glued in position onto the heat absorbing base plate (20) to finish the assembly of the heat dissipation leaves of the invention herein; after assembling, since the width of the retaining portion defines a certain interval distance among the heat dissipation leaves (10), and the bent heat dissipation poles (11) are staggered fore and aft in rows, every surface of the all the heat dissipation poles (11) can evenly contact with the air current to enable the entire heat dissipation leaves to fulfill the heat dissipation efficiency and continuously and quickly diffuses the heat; furthermore, the heat conducting pieces (13) on the bottom ends of the hear dissipation leaves (10) can be constructed with the bottom retaining slots (14) as an unit; after assembling the heat dissipation leaves (10), the bottom portions will form a compact contact surface for heat conduction through the connection and combination among all the heat conducting pieces (13) to substantially increase the contact areas for absorbing the heat source with the heat absorbing base plate (20) and to make the heat dissipation leaves (10) achieve the best heat conduction and heat dissipation effect.

However, the terminology utilized for the said drawings and components have been selected to facilitate the description of the invention herein and shall not be construed as a limitation on the patented scope of the invention herein; all substitutions of equivalent components based on the spirit of the invention herein shall still be regarded as within the protected scope and of the new patent rights granted to the invention herein.

In summation of the foregoing sections, the invention herein of a leaf piece structure for a heat dissipater is an invention of reasonable perfection, possessing not only excellent practicality, but also an unprecedented structural spatial design that is original, innovational and capable of manifestly increasing the rate of heat dissipation and specifically enhancing the heat dissipation efficiency, is an invention of high characteristics surpassing the conventional technology and is progressive; therefore, the invention herein fully complies with all new patent application requirements and is hereby submitted to the patent bureau for review and the granting of the commensurate patent rights.

## Claims

1. A leaf piece structure for a heat dissipater is mainly constructed by heat dissipation piece as a whole and the heat dissipation leaves are directly punch pressed into heat dissipation poles arranged in a plurality of rows; the dissipation poles are bent and staggered fore and aft in rows with intervals; the retaining portions are formed by bending the two sides on the top end and the bottom end respectively; the bottom end is also bent to form a heat conducting plate in the shape of a long piece; the retaining tenons are mounted and facing toward the front direction at the front portions of the retaining slots on the retaining portion to be aligned and retained correspondingly with all the heat dissipation leaves with a certain interval distance during assembling.
